# EUROPÄISCHE PATENTSCHRIFT

(11) **EP 2 031 945 B1**
(45) Veröffentlichungstag und Bekanntmachung des Hinweises auf die Patenterteilung: **01.05.2019**
(21) Anmeldenummer: 08014607.9
(22) Anmeldetag: 18.08.2008
(51) Int. Cl.: H05K 3/34

(54) **Verfahren zur Montage von elektronischen Bauteilen und elektromechanischen Komponenten auf einer Leiterplatte**
Method for mounting electronic components and electromechanical components on a circuit board
Procédé de montage de composants électroniques et composants électroniques comprenant une plaquette

(30) Priorität: 27.08.2007 DE 102007040662
(43) Veröffentlichungstag der Anmeldung: 04.03.2009
(73) Patentinhaber: Elster Messtechnik GmbH, 68623 Lampertheim (DE)
(72) Erfinder: Ohlemüller, Patrick, 69469 Weinheim (DE)
(74) Vertreter: Miller, Toivo

(56) Entgegenhaltungen:
- DE-A1- 10 349 956
- US-A- 4 530 002
- US-A1- 2003 006 061

## Beschreibung

Die Erfindung betrifft ein Verfahren zur Montage von elektronischen Bauteilen oder elektromechanischen Komponenten, nachfolgend auch als elektrische Komponenten bezeichnet, auf einer Leiterplatte, nach dem Oberbegriff des Patentanspruches 1 sowie eine Anordnung aus wenigstens einer Leiterplatte zur Aufnahme von elektronischen Bauteilen oder elektromechanischen Komponenten gemäß dem Verfahren nach Anspruch 1.

Zur Bestückung bzw. Fixierung elektrischer Leiterplatten, auch als gedruckte Schaltungen oder Platinen bezeichnet, mit elektronischen Bauteilen oder elektromechanischen Komponenten sind verschiedene Verfahren bekannt.

In der DE 103 49 956 A1 ist ein Verfahren beschrieben, bei dem elektrisches Bauteile , wie Widerstände, Transistoren, Kondensatoren oder Spulen auf einer Leiterplatter befestigt werden.

Zur Montage von diskreten Bauteilen, wie beispielsweise Spulen, Widerständen oder Kondensatoren oder von Bauteilen mit einer größeren Abmessung bzw. mit einer großen Masse, wie beispielsweise Transformatoren oder Netzteile zur Strom - und Spannungsversorgung, weisen die elektronischen Bauteile und elektromechanischen Komponenten elektrisch leitende Stifte bzw. Anschlussdrähte - sogenannte Anschlusspins - auf. Zur elektrischen Kontaktierung werden die Anschlusspins auf der Bestückungsseite der Leiterplatte durch vorgesehene Durchgangsbohrungen der Leiterplatte gesteckt und danach auf der gegenüberliegenden Seite, welche auch als Verdrahtungsseite bezeichnet wird, verlötet.

Durch die auf der Verdrahtungsseite der Leiterplatte aufgebrachten Lötverbindungen zur Fixierung der elektrischen Komponenten wird neben der Bildung einer elektrischen Verbindung zwischen den auf der Leiterplatte befindlichen Leiterbahnen und den elektronischen Komponenten auch eine mechanische Fixierung der Komponenten auf der Leiterplatte erreicht. Dieses Montageverfahren wird auch "Through the hole technology (THT)" genannt.

Zur Gewährleistung der elektrischen Sicherheit ist es erforderlich vorgegebene Normen einzuhalten, welche zwischen bestimmten Leiteranordnungen Mindestabstände, auch als sogenannte Luft- und Kriechstrecken bekannt, erfordern. Diese Abstände müssen auch auf Leiterplatten, den Luftstrecken und den Zwischenebenen bei einer Durchkontaktierung eingehalten werden. Hier jedoch nur auf den jeweiligen für die Durchkontaktierung genutzten Oberflächen und Ebenen der Leiterplatten, jedoch nicht zwischen den Leiterebenen, da diese durch einen Isolierstoff sicher voneinander isoliert sind, welcher eine sichere elektrische Trennung der Leiter gewährleistet. Dazu wird die Leiterplatte beispielsweise mit einigen elektrischen Komponenten auf der Oberseite der Leiterplatte und einigen elektrischen Komponenten auf der Unterseite einer Leiterplatte bestückt.

Die vorab beschriebene Anordnung der elektrischen Komponenten und Leiterbahnen auf beiden Seiten der Leiterplatte führt dazu, dass durch die Lötstifte der Komponenten eine leitfähige Verbindung zwischen Ober- und Unterseite sowie allen anderen Leiterebenen geschaffen wird - obwohl eigentlich nur die Kontaktierung einer Leiterplattenseite notwendig wäre. Somit wird es notwendig die vorgegebenen elektrischen Sicherheitsabstände um die Lötverbindungen an den Anschlusspins herum auf allen Ebenen einzuhalten, was die nutzbare Leiterplattenfläche für eine möglichst maximale Ausnutzung der Leiterplattenfläche für die Bestückung und Verdrahtung mit den elektrischen Komponenten erheblich reduziert.

Eine gegenwärtig bevorzugte Technologie zur Bestückung von Leiterplatten mit elektronischen Bauteilen ist die Oberflächenmontage, auch als "Surface mount devices technology (SMD)" bezeichnet, welche eine bessere Ausnutzung der Leiterplattenfläche ermöglicht. Dabei werden die elektronischen Bauteile direkt auf der Bestückungsseite der Leiterplatte aufgeklebt und die Kontaktstellen der Bauteile mit den auf der Leiterpatte aufgebrachten elektrischen Leiterbahnen verlötet, ohne dass Öffnungen bzw. Durchgangsbohrungen in der Leiterplatte erforderlich sind, und demzufolge keine Pins durch in der Leiterpatte vorzusehende Durchgangsbohrungen gesteckt werden müssen.

Das SMD-Verfahren eignet sich jedoch nur für Bauteile mit einem geringen Gewicht und geringen Abmessungen. Da die elektronischen Bauteile mittels dem SMD-Verfahren nur auf einer Seite der Leiterplatte befestigt, vorzugsweise geklebt, und verlötet werden, können sich Bauteile großer Masse von der Leiterplatte lösen, weil die SMD-Lötpads sonst abreißen könnten.

Elektromechanischen Komponenten, wie Transformatoren, Netzteile sowie Kondensatoren oder Spulen größerer Abmessungen, sind auf Grund ihres Gewichtes und/oder ihrer Abmessungen mittels des SMD- Verfahrens nicht mechanisch stabil auf der Leiterplatte montierbar, so dass diese elektromechanischen Komponenten beim Transport der bestückten Leiterplatte oder anderen Erschütterungen abreißen.

Ausgehend von den beschriebenen Nachteilen liegt der Erfindung demgemäß die Aufgabe zugrunde, die Montage von elektrischen Komponenten, insbesondere von diskreten Bauteilen, wie Spulen, Widerständen oder Kondensatoren sowie von elektromechanischen Komponenten, wie Transformatoren oder Netzteilen in einfacher Weise zu verbessern, und insbesondere eine ausreichende mechanische Stabilität der elektrischen Komponenten auf der Leiterplatte zu erreichen und trotzdem auf der anderen Seite Bauteile bestücken können, weil dort keine Luft-/Kriechstrecken eingehalten werden müssen.

Diese Aufgabe wird erfindungsgemäß mit den in Anspruch 1 angegebenen Merkmalen gelöst. Vorteilhafte Ausgestaltungen, Verbesserungen der erfindungsgemäßen Einrichtung sowie eine Anordnung zur Aufnahme von elektronischen Komponenten gemäß dem Verfahren nach Anspruch 1 sind in weiteren Ansprüchen und in der Beschreibung angegeben.

Zur Durchführung des erfindungsgemäßen Verfahrens werden elektronische Bauteilen und/oder elektromechanische Komponenten mit jeweils mehreren Anschlusspins verwendet. Einige dieser Anschlusspins, sogenannte mechanische Anschlusspins oder Leerpins, sind dafür vorgesehen die elektronischen Bauteile und/oder elektromechanischen Komponenten mechanisch sicher auf der Leiterplatte zu befestigen.

Das erfindungsgemäße Verfahren zur Montage der elektrischen Komponenten auf einer Leiterplatte umfasst die nachfolgend aufgeführten Verfahrensschritte.

In einem ersten Verfahrensschritt werden Anschlusspins, welche insbesondere zur Einhaltung vorgegebener Normen, wie beispielsweise mit einer Luft-/ und Kriechstrecke von 6,3mm der 230V- Leitungen umgebogen oder abgewinkelt. Mittels der umgebogenen Anschlusspins wird erreicht, dass die jeweilige elektrische Komponente auf der Bestückungsseite der Leiterplatte aufsetzbar ist und das elektrische Potential von anderen Leiterplattenebenen ferngehalten wird. Die umgebogenen Anschlusspins werden im folgendem als mit Strom oder Spannung beaufschlagte Anschlusspins oder elektrisch leitende Anschlusspins bezeichnet.

In einem zweiten Verfahrensschritt werden die mechanischen Leerpins der elektrischen Komponenten, welche vorab nicht mechanisch verformt bzw. umgebogen wurden durch in der Leiterplatte vorgesehene Durchgangsbohrungen geführt, wodurch die jeweilige elektrische Komponente und die umgebogenen elektrisch leitenden Anschlusspins auf der Bestückungsseite der Leiterplatte aufgesetzt werden.

In einem abschließenden Verfahrensschritt werden die mechanischen und elektrisch leitenden Anschlusspins fixiert, vorzugsweise verlötet.

In einer vorteilhaften Ausführungsform des erfindungsgemäßen Verfahrens werden zuerst die durch die Durchgangsbohrungen der Leiterplatte geführten mechanischen Leerpins und danach die elektrisch leitenden Anschlusspins, welche auf der Bestückungsseite der Leiterplatte aufliegen, verlötet. Dadurch wird in vorteilhafter Weise gewährleistet, dass die elektrisch leitenden Anschlusspins nur einer geringen mechanischen Belastung ausgesetzt sind, weil die mechanische Hauptbelastung an den bereits durchgesteckten, verlöteten Pins liegt.

Mit dem erfindungsgemäßen Verfahren wird somit in vorteilhafter Weise die mechanische Fixierung von elektronischen Bauteile und/oder elektromechanischen Komponenten auf Leiterplatten, die üblicherweise durch den elektrisch-leitenden Anschlusspin gewährleistet wird, von der elektrischen Kontaktierung getrennt und eine mechanisch festere Verbindung der elektrischen Komponenten auf der Leiterplatte erreicht, wobei die durch die Durchgangsbohrungen der Leiterplatte geführten und auf der Verdrahtungsseite der Leiterplatte verlöteten mechanischen Leerpins der Stabilität der elektrischen Komponente dienen und die auf der Bestückungsseite der Leiterplatte aufgesetzten und verlöteten abgewinkelten elektrisch leitenden Anschlusspins zur elektrischen Kontaktierung vorgesehen sind.

Ein weiterer Vorteil des erfindungsgemäßen Verfahrens beruht darauf, dass durch das Umbiegen der mit Strom oder Spannung beaufschlagbaren Anschlusspins und deren Verlötung auf der Bestückungsseite nur auf der Bestückungsseite die norm-geregelten Anforderungen zu berücksichtigen sind. Dies führt zu einer besseren Auslastung der Bestückungsoberfläche der Leiterplatte und somit zur Einsparung von Leiterplattenfläche; ferner noch einer besseren Auslastung der Leiterbahnfläche der verschiedenen Leiterplattenebenen.

Eine Anordnung zur Aufnahme von elektronischen Bauteilen und/oder elektromechanischen Komponenten auf einer Leiterplatte mit der die Aufgabe weiterhin gelöst wird, ist dem Anspruch 8 zu entnehmen.

Die erfindungsgemäße Anordnung umfasst wenigstens eine Leiterplatte zur Aufnahme von elektronischen Bauteilen und/oder elektromechanischen Komponenten, welche mehrere Anschlusspins, auch als Anschlussdrähte bezeichnet, aufweisen.

Einige dieser Anschlusspins, sogenannte mechanische Anschlusspins oder Leerpins, sind zur mechanisch sicheren Befestigung der elektronischen Bauteile und/oder elektromechanischen Komponenten auf der Leiterplatte vorgesehen.

Die mit Strom oder Spannung beaufschlagten elektrischen Anschlusspins sind so umbiegbar, dass diese zur Kontaktierung auf der Bestückungsseite der Leiterplatte aufsetzbar sind.

Die mechanischen Leerpins der elektrischen Komponenten, welche vorab nicht mechanisch verformt bzw. umgebogen wurden, sind durch in der Leiterplatte vorgesehenen Durchgangsbohrungen führbar, wodurch die jeweilige elektrische Komponente und die umgebogenen elektrisch leitenden Anschlusspins auf der Bestückungsseite der Leiterplatte aufsetzbar sind.

Die Fixierung der elektrischen Komponenten auf der Leiterplatte erfolgt durch ein Verlöten der mechanischen und elektrisch leitenden Anschlusspins.

Erfindungsgemäß sind nunmehr die mit Strom oder Spannung beaufschlagbaren Anschlusspins auf der Bestückungsseite und die mechanischen Anschlusspins auf der Verdrahtungsseite der Leiterplatte verlötet.

Die Pins der Niederspannungsseite (Sekundärseite) des Trafos sind zwar elektrisch leitend, müssen aber nicht abgeknickt werden, weil hierbei nur geringe Luft-/und Kriechstrecken erforderlich sind.

Die mechanischen Anschlusspins sind in einer weiteren Ausführungsform verpressbar. Dazu ist der jeweilige mechanische Anschlusspin als Widerhaken ausgebildet und wird nicht verlötet sondern nur durch die Durchgangsbohrung gesteckt, wodurch kein Lötzinn mehr für diese Komponente benötigt wird.

In einer bevorzugten Ausführungsform, beispielsweise bei der Bestückung der Leiterplatte mit einem Transformator, ist vorgesehen, die elektrisch leitenden Anschlusspins, welche auf der Bestückungsseite der Leiterplatte aufsetzbar sind, so zu verlängern, dass sie beim Aufsetzen des Transformators auf die Leiterplatte nicht komplett von Gehäuse des Transformators verdeckt werden. Somit wird die Durchführbarkeit des Lötvorganges durch eine verbesserte Zugänglichkeit der elektrisch leitenden Anschlusspins verbessert.

Um eine geforderte mechanische Stabilität zu gewährleisten, werden in einer besonderen Ausführung der Erfindung zusätzliche Anschlusspins, auch Leerpins genannt, in den Körper der elektrischen Komponente eingebaut. Diese Leerpins werden ebenfalls durch die in der Leiterplatte vorgesehenen Durchgangsbohrungen gesteckt und anschließend der Verdrahtungsseite verlötet.

Da die Leerpins der elektrischen Komponenten, beispielsweise bei einem Transformator, nunmehr galvanisch von der Hochspannung getrennt trennen sind, unterliegen die Leerpins keinen norm-geregelten Anforderungen für die gegenüberliegende Bestückungsseite der Leiterplatte und die dazwischenliegenden Ebenen.

Besonders vorteilhaft erweist sich dabei der Einbau von Leerpins in einen Spulenkörper, wobei die Leerpins ebenfalls von der Bestückungsseite der Leiterplatte aus durch die Durchgangsöffnungen in der Leiterplatte geführt werden, um so eine verbesserte mechanische Stabilität zu gewährleisten. Diese zusätzlichen Leerpins sind galvanisch von der Hochspannung getrennt und somit entfallen die norm-geregelten Anforderungen für die gegenüberliegende Bestückungsseite.

Anhand der in den folgenden Figuren dargestellten Ausführungsbeispiele sollen die Erfindung sowie vorteilhafte Ausgestaltungen, Verbesserungen und weitere Vorteile der Erfindung näher erläutert und beschrieben werden.

Es zeigen:

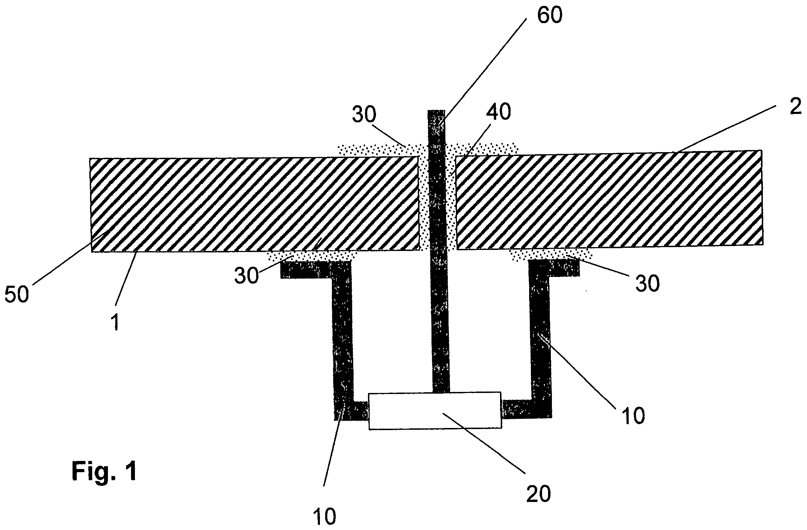

- **Fig.** 1: eine Ausführungsform der erfindungsgemäßen Anordnung zur Montage von elektrischen Komponenten, und
- **Fig.** 2: eine beispielhafte elektromechanische Komponente, welche zur Montage auf einer Leiterplatte vorgesehen ist.

Unter elektrischen Komponenten sollen elektronische Bauteile oder elektromechanischen Komponenten verstanden werden, welche mehrere Anschlussdrähte oder Anschlusspins 10, 60 aufweisen, die an einer Kontaktierstelle verlötbar sind.

Die erfindungsgemäße Anordnung wird aus einer Leiterplatte 50 zur Aufnahme von wenigstens einer elektrischen Komponente 20 gebildet, wobei die elektrische Komponente 20 drei Anschlusspins 10 aufweist und nur auf einer Seite, der Bestückungsseite 1 auf die Leiterplatte 50, aufgesetzt ist.

Ein sogenanntes mechanisches Anschlusspin 60, welches vorab nicht mechanisch verformt bzw. umgebogen wurde, ist zur mechanisch sicheren Befestigung der elektrischen Komponente 20 auf der Leiterplatte 50 vorgesehen. Das mechanische Anschlusspin 60 ist dazu von der Bestückungsseite 1 aus durch eine in der Leiterplatte 50 vorhandene Durchgangsöffnung bzw. -bohrung 40 geführt.

Die mit Strom oder Spannung beaufschlagten elektrischen Anschlusspins 10 sind so umgebogen, dass diese zur Kontaktierung auf der Bestückungsseite 1 der Leiterplatte 50 aufsetzbar sind.

Zur Fixierung der elektrischen Komponente 20 auf der Leiterplatte 50 werden die elektrischen und der mechanische Anschlusspin 10, 60 jeweils an einer mit Lotpaste 30 oder Zinnwelle versehenen Kontaktierungsstelle so verlötet, dass die elektrisch leitenden Anschlusspins 10 auf der Bestückungsseite 1 und der mechanischen Anschlusspin 60 auf der Verdrahtungsseite 2 der Leiterplatte 50, vorzugsweise mittels eines automatisch ablaufendem Lötprozesses, verlötet sind.

Die verlöteten elektrisch leitenden Anschlusspins 10 bilden so die elektrische Kontaktierung der elektrischen Komponente 20 mit auf der Leiterplatte 50 befindlichen Leiterbahnen und der verlötete mechanische Anschlusspin 60 bildet eine mechanisch stabile Verbindung der elektrischen Komponente 20 mit der Leiterplatte 50.

Somit liegt die mechanische Beanspruchung der elektrischen Komponente 20 vorteilhafterweise an den durch die Durchgangsöffnungen 40 durchgesteckten mechanischen Anschlusspins 60 an und ein Abreißen der elektrischen Komponente 20 von der Leiterplatte wird dadurch minimiert.

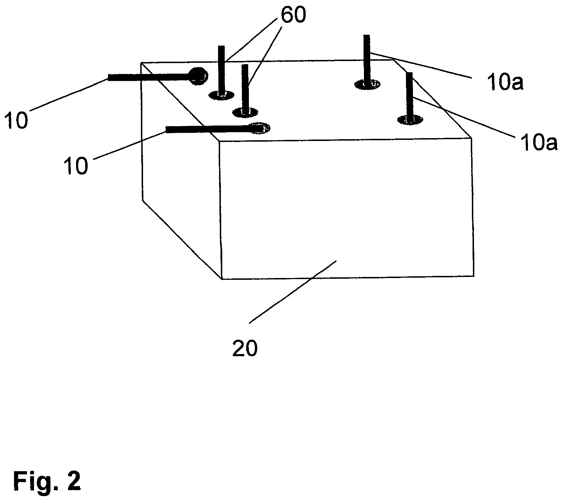

**Fig.** 2 zeigt als elektromechanische Komponente 20 einen Transformator mit sechs Anschlusspins 10, 10a, 60, welcher zur Montage auf einer Leiterplatte 50 vorgesehen ist.

Die hochspannungsbeaufschlagbaren elektrisch leitenden Anschlusspins 10 des Transformators 20 sind rechtwinklig abgebogen und werden auf der Bestückungsseite 1 aufgesetzt und dort auch verlötet. Somit müssen Luft-Kriechstrecken nur auf der Bestückungsseite eingehalten werden.

Bei dem in der **Fig.** 2 gezeigten Transformator ist die Länge der elektrisch leitenden Anschlusspins 10 vorzugsweise so bemessen, dass diese nach ihrer Verformung teilweise über die Transformatoraußenseite herausragen. Somit sind die über die Außenseite des Transformators 20 herausragenden umgebogenen elektrisch leitenden Anschlusspins 10 einfach verlötbar, wenn der Transformator 20 der Platine 50 aufgesetzt ist. Insbesondere bei einem manuell ausgeführten Lötvorgang erweisen sich die die über die Außenseite des Transformators 20 herausragenden umgebogenen elektrisch leitenden Anschlusspins 10 als vorteilhaft

Die mechanischen Anschlusspins 60 sowie elektrisch leitende Anschlusspins 10a für die keine großen Luft-Kriechstrecken gelten, weil diese keine hohen Spannungen führen, werden in der Ausführungsform gemäß **Fig.** 2 nicht umgebogen sondern werden gemäß dem erfindungsgemäßen Verfahrens von der Bestückungsseite 1 aus durch die in der Leiterplatte 50 vorgesehenen Durchgangsöffnungen 40 geführt und verlötet.

Die keine Hochspannung führenden elektrischen Anschlusspins 10a sind üblicherweise auf der Sekundärseite des Transformators 20 angeordnet.

### Bezugszeichenliste

- 1: Bestückungsseite der Leiterplatte
- 2: Verdrahtungsseite der Leiterplatte
- 10, 10a: elektrischer Anschlusspin
- 20: elektrische Komponente
- 30: Auftrag der Lotpaste
- 40: Durchgangsbohrung
- 50: Leiterplatte
- 60: mechanischer Anschlusspin

## Patentansprüche

1. Verfahren zur Montage wenigstens einer elektromechanischen Komponente (20), wie eines Transformators, und/oder eines Netzteils auf einer Leiterplatte (50), wobei die wenigstens eine elektromechanische Komponente (20) mehrere elektrisch leitende Anschlusspins (10) sowie wenigstens ein mechanisches Anschlusspin (60) aufweist und auf einer Seite, der Bestückungsseite (1), auf die Leiterplatte (50), aufgesetzt wird, wobei das Verfahren die folgende Verfahrensschritte umfasst:
a) wenigstens zwei elektrisch leitende Anschlusspins (10) der elektromechanischen Komponente (20) werden umgebogen,
b) das wenigstens eine mechanische Anschlusspin (60) der elektromechanischen Komponente (20) wird durch eine in der Leiterplatte (50) vorgesehene Durchgangsbohrung (40) geführt, wodurch die jeweilige elektromechanische Komponente (20) und die umgebogenen elektrisch leitenden Anschlusspins (10) auf der Bestückungsseite (1) der Leiterplatte (50) aufgesetzt werden,
c) nach dem Aufsetzen der elektromechanischen Komponente (20) auf der Leiterplatte (50) werden die wenigstens zwei umgebogenen elektrisch leitenden Anschlusspins (10) auf der Bestückungsseite (1) der Leiterplatte (50) und die mechanischen Anschlusspins (60) auf der der Bestückungsseite (1) der Leiterplatte (50) gegenüberliegenden Verdrahtungsseite (2) verlötet, **dadurch gekennzeichnet, dass**
d) die elektromechanischen Komponenten (20) mit zusätzlichen Anschlusspins, auch Leerpins genannt, ausgeführt werden, wobei die Leerpins durch in der Leiterplatte (50) vorgesehene Durchgangsbohrungen (40) gesteckt und auf der Verdrahtungsseite (2) verlötet werden.

2. Verfahren nach Anspruch 1, **dadurch gekennzeichnet, dass** nur die elektrisch leitenden Anschlusspins (10), welche zur Einhaltung vorgegebener Normen vorgesehen sind, umgebogen und auf der Bestückungsseite (1) verlötet werden.

3. Verfahren nach einem der vorherigen Ansprüche, **dadurch gekennzeichnet, dass** die umgebogenen elektrisch leitenden Anschlusspins (10) mit einer vorgegebenen Länge über die Außenseite der elektromechanischen Komponente (20) hinausgeführt werden.

4. Verfahren nach einem der vorherigen Ansprüche, **dadurch gekennzeichnet, dass** die Leerpins galvanisch von einer an der elektromechanischen Komponente (20) anliegenden Hochspannung getrennt werden.

5. Verfahren nach einem der vorherigen Ansprüche, **dadurch gekennzeichnet, dass** zuerst die durch die Durchgangsbohrungen (40) der Leiterplatte (50) geführten Anschlusspins (60), (10a) auf der Verdrahtungsseite (2) und danach die umgebogenen elektrisch leitenden Anschlusspins (10), welche auf der Bestückungsseite (1) der Leiterplatte (50) aufliegen, verlötet werden.

6. Verfahren nach einem der vorherigen Ansprüche, **dadurch gekennzeichnet, dass** elektrisch leitende Anschlusspins (10a), die keine hohen Spannungen führen, nicht umgebogen werden, sondern von der Bestückungsseite (1) aus durch die in der Leiterplatte (50) vorgesehenen Durchgangsöffnungen (40) geführt und verlötet werden.

7. Anordnung aus einer Leiterplatte (50) zur Aufnahme von wenigstens einer elektromechanischen Komponente (20), wie eines Transformators, und/oder eines Netzteils, auf der Leiterplatte (50), wobei
a) die wenigstens eine elektromechanische Komponente (20) mehrere elektrisch leitende Anschlusspins (10) sowie wenigstens ein mechanisches Anschlusspin (60) aufweist und auf einer Seite, der Bestückungsseite (1), auf die Leiterplatte (50), aufsetzbar ist,
b) wenigstens zwei elektrisch leitende Anschlusspins (10) der elektromechanischen Komponente (20) umgebogen sind,
c) das wenigstens eine mechanische Anschlusspin (60) der elektromechanischen Komponente (20) durch eine in der Leiterplatte (50) vorgesehene Durchgangsbohrung (40) geführt ist, wodurch die jeweilige elektromechanische Komponente (20) und die umgebogenen elektrisch leitenden Anschlusspins (10) auf der Bestückungsseite (1) der Leiterplatte (50) aufgesetzt sind,
d) nach dem Aufsetzen der elektromechanischen Komponente (20) auf der Leiterplatte (50) die wenigstens zwei umgebogenen elektrisch leitenden Anschlusspins (10) auf der Bestückungsseite (1) der Leiterplatte (50) und die mechanischen Anschlusspins (60) auf der der Bestückungsseite (1) der Leiterplatte (50) gegenüberliegenden Verdrahtungsseite (2) verlötet sind, **dadurch gekennzeichnet, dass**
e) die elektromechanischen Komponenten (20) mit zusätzlichen Anschlusspins, auch Leerpins genannt, ausgeführt sind, wobei die Leerpins durch in der Leiterplatte (50) vorgesehene Durchgangsbohrungen (40) gesteckt und auf der Verdrahtungsseite (2) verlötet sind.

8. Anordnung nach Anspruch 7, **dadurch gekennzeichnet, dass** nur die elektrisch leitenden Anschlusspins (10), welche zur Einhaltung vorgegebener Normen vorgesehen sind, umgebogen und auf der Bestückungsseite (1) verlötet sind.

9. Anordnung nach einem der Ansprüche 7 oder 8, **dadurch gekennzeichnet, dass** die umgebogenen elektrisch leitenden Anschlusspins (10) mit einer vorgegebenen Länge über die Außenseite der elektromechanischen Komponente (20) hinausgeführt sind.

10. Anordnung nach einem der Ansprüche 7 bis 9, **dadurch gekennzeichnet, dass** die Leerpins galvanisch von einer an der elektromechanischen Komponente (20) anliegenden Hochspannung getrennt sind.

11. Anordnung nach einem der Ansprüche 7 bis 10, **dadurch gekennzeichnet, dass** elektrisch leitende Anschlusspins (10a), die keine hohen Spannungen führen, nicht umgebogen sind, sondern von der Bestückungsseite (1) aus durch die in der Leiterplatte (50) vorgesehenen Durchgangsöffnungen (40) geführt und verlötet sind.

12. Anordnung nach einem der einem der Ansprüche 7 bis 11, **dadurch gekennzeichnet, dass** die elektromechanischen Komponenten (20) Transformatoren und/oder Netzteile sind, die auf Grund ihres Gewichtes und/oder ihrer Abmessungen mittels eines SMD-Verfahrens nicht mechanisch stabil auf einer Leiterplatte montierbar sind.

## Claims

1. Method for mounting at least one electromechanical component (20), such as a transformer, and/or a power supply unit on a printed circuit board (50), wherein the at least one electromechanical component (20) has a plurality of electrically conductive connection pins (10) and also at least one mechanical connection pin (60) and is fitted onto the printed circuit board (50) on one side, the component side (1), wherein the method comprises the following method steps:
a) at least two electrically conductive connection pins (10) of the electromechanical component (20) are bent over,
b) the at least one mechanical connection pin (60) of the electromechanical component (20) is guided through a passage bore (40) which is provided in the printed circuit board (50), as a result of which the respective electromechanical component (20) and the bent-over electrically conductive connection pins (10) are fitted on the component side (1) of the printed circuit board (50),
c) after fitting the electromechanical component (20) on the printed circuit board (50), the at least two bent-over electrically conductive connection pins (10) are soldered on the component side (1) of the printed circuit board (50) and the mechanical connection pins (60) are soldered on the wiring side (2) which is situated opposite the component side (1) of the printed circuit board (50), **characterized in that**
d) the electromechanical components (20) are designed with additional connection pins, also called dummy pins, wherein the dummy pins are inserted through passage bores (40) provided in the printed circuit board (50) and are soldered on the wiring side (2).

2. Method according to Claim 1, **characterized in that** only the electrically conductive connection pins (10), which are provided for complying with prespecified standards, are bent over and soldered on the component side (1).

3. Method according to either of the preceding claims, **characterized in that** the bent-over electrically conductive connection pins (10) are guided beyond the outside of the electromechanical component (20) by a prespecified length.

4. Method according to one of the preceding claims, **characterized in that** the dummy pins are DC-isolated from a high voltage which is applied to the electromechanical component (20).

5. Method according to one of the preceding claims, **characterized in that** first the connection pins (60), (10a) which are guided through the passage bores (40) of the printed circuit board (50) are soldered on the wiring side (2) and then the bent-over electrically conductive connection pins (10), which lie on the component side (1) of the printed circuit board (50), are soldered.

6. Method according to one of the preceding claims, **characterized in that** electrically conductive connection pins (10a) which do not carry high voltages are not bent over but rather are guided from the component side (1) through the passage openings (40) provided in the printed circuit board (50) and are soldered.

7. Arrangement comprising a printed circuit board (50) for receiving at least one electromechanical component (20), such as a transformer, and/or a power supply unit on the printed circuit board (50), wherein
a) the at least one electromechanical component (20) has a plurality of electrically conductive connection pins (10) and also at least one mechanical connection pin (60) and can be fitted on the printed circuit board (50) on one side, the component side (1),
b) at least two electrically conductive connection pins (10) of the electromechanical component (20) are bent over,
c) the at least one mechanical connection pin (60) of the electromechanical component (20) is guided through a passage bore (40) provided in the printed circuit board (50), as a result of which the respective electromechanical component (20) and the bent-over electrically conductive connection pins (10) are fitted on the component side (1) of the printed circuit board (50),
d) after fitting the electromechanical component (20) on the printed circuit board (50), the at least two bent-over electrically conductive connection pins (10) are soldered on the component side (1) of the printed circuit board (50) and the mechanical connection pins (60) are soldered on the wiring side (2) which is situated opposite the component side (1) of the printed circuit board (50), **characterized in that**
e) the electromechanical components (20) are designed with additional connection pins, also called dummy pins, wherein the dummy pins are inserted through passage bores (40) which are provided in the printed circuit board (50) and are soldered on the wiring side (2) .

8. Arrangement according to Claim 7, **characterized in that** only the electrically conductive connection pins (10), which are provided for complying with prespecified standards, are bent over and soldered on the component side (1).

9. Arrangement according to either of Claims 7 and 8, **characterized in that** the bent-over electrically conductive connection pins (10) are guided beyond the outside of the electromechanical component (20) by a prespecified length.

10. Arrangement according to one of Claims 7 to 9, **characterized in that** the dummy pins are DC-isolated from a high voltage which is applied to the electromechanical component (20).

11. Arrangement according to one of Claims 7 to 10, **characterized in that** electrically conductive connection pins (10a) which do not carry high voltages are not bent over but rather are guided from the component side (1) through the passage openings (40) which are provided in the printed circuit board (50) and soldered.

12. Arrangement according to one of one of Claims 7 to 11, **characterized in that** the electromechanical components (20) are transformers and/or power supply units which, on account of their weight and/or their dimensions, cannot be mounted on a printed circuit board in a mechanically stable manner by means of an SMD process.

## Revendications

1. Procédé de montage d'au moins un composant électromécanique (20), comme un transformateur et/ou un bloc d'alimentation secteur sur un circuit imprimé (50), l'au moins un composant électromécanique (20) possédant plusieurs broches de raccordement électriquement conductrices (10) ainsi qu'au moins une broche de raccordement mécanique (60) et étant posé sur un côté, le côté implantation (1), sur le circuit imprimé (50), le procédé comprenant les étapes de procédé suivantes :
a) au moins deux broches de raccordement électriquement conductrices (10) du composant électromécanique (20) sont repliées,
b) l'au moins une broche de raccordement mécanique (60) du composant électromécanique (20) est passée à travers un trou traversant (40) présent dans le circuit imprimé (50), moyennant quoi le composant électromécanique (20) respectif et les broches de raccordement électriquement conductrices (10) repliées sont posés sur le côté implantation (1) du circuit imprimé (50),
c) après avoir posé le composant électromécanique (20) sur le circuit imprimé (50), les au moins deux broches de raccordement électriquement conductrices (10) repliées sont brasées sur le côté implantation (1) du circuit imprimé (50) et les broches de raccordement mécaniques (60) sur le côté câblage (2), à l'opposé du côté implantation (1) du circuit imprimé (50), **caractérisé en ce que**
d) les composants électromécaniques (20) sont réalisés avec des broches de raccordement supplémentaires, également appelées broches factices, les broches factices étant insérées à travers des trous traversants (40) présents dans le circuit imprimé (50) et brasées sur le côté câblage (2).

2. Procédé selon la revendication 1, **caractérisé en ce que** seules sont recourbées et brasées sur le côté implantation (1) les broches de raccordement électriquement conductrices (10) qui sont destinées à respecter des normes prédéfinies.

3. Procédé selon l'une des revendications précédentes, **caractérisé en ce que** les broches de raccordement électriquement conductrices (10) recourbées sont sorties avec une longueur prédéfinie au-dessus du côté extérieur du composant électromécanique (20).

4. Procédé selon l'une des revendications précédentes, **caractérisé en ce que** les broches factices sont isolées galvaniquement d'une haute tension appliquée au composant électromécanique (20).

5. Procédé selon l'une des revendications précédentes, **caractérisé en ce que** sont brasées tout d'abord les broches de raccordement (60), (10a) passées à travers les trous traversants (40) du circuit imprimé (50) sur le côté câblage (2) et ensuite les broches de raccordement électriquement conductrices (10) repliées, lesquelles reposent sur le côté implantation (1) du circuit imprimé (50).

6. Procédé selon l'une des revendications précédentes, **caractérisé en ce que** des broches de raccordement électriquement conductrices (10a) qui ne conduisent pas de tensions élevées ne sont pas recourbées, mais passées à travers les trous traversants (40) présents dans le circuit imprimé (50) depuis le côté implantation (1) et brasées.

7. Arrangement constitué d'un circuit imprimé (50) destiné à accueillir au moins un composant électromécanique (20), comme un transformateur et/ou un bloc d'alimentation secteur, sur le circuit imprimé (50),
a) l'au moins un composant électromécanique (20) possédant plusieurs broches de raccordement électriquement conductrices (10) ainsi qu'au moins une broche de raccordement mécanique (60) et pouvant être posé sur un côté, le côté implantation (1), sur le circuit imprimé (50),
b) au moins deux broches de raccordement électriquement conductrices (10) du composant électromécanique (20) étant repliées,
c) l'au moins une broche de raccordement mécanique (60) du composant électromécanique (20) étant passée à travers un trou traversant (40) présent dans le circuit imprimé (50), moyennant quoi le composant électromécanique (20) respectif et les broches de raccordement électriquement conductrices (10) repliées sont posés sur le côté implantation (1) du circuit imprimé (50),
d) après avoir posé le composant électromécanique (20) sur le circuit imprimé (50), les au moins deux broches de raccordement électriquement conductrices (10) repliées étant brasées sur le côté implantation (1) du circuit imprimé (50) et les broches de raccordement mécaniques (60) sur le côté câblage (2), à l'opposé du côté implantation (1) du circuit imprimé (50),
**caractérisé en ce que**
e) les composants électromécaniques (20) sont réalisés avec des broches de raccordement supplémentaires, également appelées broches factices, les broches factices étant insérées à travers des trous traversants (40) présents dans le circuit imprimé (50) et brasées sur le côté câblage (2).

8. Arrangement selon la revendication 7, **caractérisé en ce que** seules sont recourbées et brasées sur le côté implantation (1) les broches de raccordement électriquement conductrices (10) qui sont destinées à respecter des normes prédéfinies.

9. Arrangement selon l'une des revendications 7 ou 8, **caractérisé en ce que** les broches de raccordement électriquement conductrices (10) repliées sont sorties avec une longueur prédéfinie au-dessus du côté extérieur du composant électromécanique (20).

10. Arrangement selon l'une des revendications 7 à 9, **caractérisé en ce que** les broches factices sont isolées galvaniquement d'une haute tension appliquée au composant électromécanique (20).

11. Arrangement selon l'une des revendications 7 à 10, **caractérisé en ce que** des broches de raccordement électriquement conductrices (10a) qui ne conduisent pas de tensions élevées ne sont pas recourbées, mais passées à travers les trous traversants (40) présents dans le circuit imprimé (50) depuis le côté implantation (1) et brasées.

12. Arrangement selon l'une des revendications 7 à 11, **caractérisé en ce que** les composants électromécaniques (20) sont des transformateurs et/ou des blocs d'alimentation secteur qui, du fait de leur poids et/ou de leurs dimensions, ne peuvent pas être montés de manière mécaniquement stable sur un circuit imprimé au moyen d'un procédé CMS.
